# EUROPEAN PATENT SPECIFICATION

(11) **EP 2 107 132 B1**
(45) Date of publication and mention of the grant of the patent: **14.09.2011**
(21) Application number: 07831980.3
(22) Date of filing: 16.11.2007
(51) Int. Cl.: C23C 14/00, C23C 14/56

(54) **WINDING VACUUM FILM FORMING PROCESS AND APPARATUS**
VERFAHREN UND VORRICHTUNG ZUR HERSTELLUNG EINER VAKUUMWICKELFOLIE
PROCÉDÉ ET APPAREIL DE FORMATION DE FILM SOUS VIDE PAR ENROULEMENT

(30) Priority: 28.11.2006 JP 2006319455
(43) Date of publication of application: 07.10.2009
(73) Proprietor: Ulvac, Inc., Chigasaki-shi Kanagawa 253-8543 (JP)
(72) Inventor: HIRONO, Takayoshi, Chigasaki-shi Kanagawa 253-8543 (JP); NOMURA, Tsunehito, Chigasaki-shi Kanagawa 253-8543 (JP); TADA, Isao, Chigasaki-shi Kanagawa 253-8543 (JP); NAKATSUKA, Atsushi, Chigasaki-shi Kanagawa 253-8543 (JP)
(74) Representative: Albutt, Anthony John
(86) International application number: PCT/JP2007/072250
(87) International publication number: WO 2008/065909

(56) References cited:
- JP-A- 11 200 045
- JP-A- 62 017 176
- JP-A- 2004 329 719

## Description

### Technical Field

The present invention relates to a roll-to-roll vacuum deposition method and a roll-to-roll vacuum deposition apparatus including a cooling roller for a base film, and more particularly, to a roll-to-roll vacuum deposition method and a roll-to-roll vacuum deposition apparatus including a cleaning unit for a cooling roller.

### Background Art

From the past, there has been known a roll-to-roll vacuum vapor deposition method that involves depositing, while causing a long base film successively paid out from a payout roller to be wound around a cooling can roller, an evaporation material from an evaporation source disposed opposite to the can roller onto the base film, and taking up the base film that has been subjected to the vapor deposition by a take-up roller (see, for example, Patent Document 1 below). In the vacuum vapor deposition method of this type, for preventing thermal deformation of the base film during the vapor deposition, deposition is carried out while the base film is in close contact with a circumferential surface of the cooling can roller so as to be cooled.

In the vacuum apparatus, dust flow in a vacuum chamber at a time of vacuum exhaustion or when being vented to atmosphere, and the dust thus easily adhere onto the can roller, guide roller, and the like. Particularly dust adhered onto the can roller inhibit the base film and the can roller from coming into close contact with each other, thereby causing a problem that a pinhole, a thermal damage of the film, and the like are caused. Therefore, for enhancing deposition quality, the circumferential surface of the can roller needs to be cleaned for the deposition.

Meanwhile, Patent Document 2 below discloses, as a dust removal apparatus for a printing sheet material or a processing sheet material, a structure of a cleaning unit including an adhesive roller that is brought into contact with a traveling sheet material to remove a foreign substance adhered onto a sheet surface. In this regard, a method of bringing the cleaning unit of this type into contact with the circumferential surface of the cooling can roller in the roll-to-roll vacuum vapor deposition apparatus described above and removing the dust adhered onto the can roller, to thus enhance adhesiveness of the can roller with the film is conceivable.

Patent Document 1: Japanese Patent No. 3795518
Patent Document 2: Japanese Patent Application Laid-open No. 2004-161491 Japanese Patent Application JP 62017176 discloses a thin film forming device wherein a base consisting of a nonmagnetic film such as PE terephthalate is moved from an unwinding reel to a take-up reel by a cooling rotary can of the thin film forming device consisting of a vacuum chamber. The cooling rotary can is cleaned by contact with an endless belt.

### Disclosure of the Invention

### Problem to be solved by the Invention

However, in the structure in which the thus-structured cleaning unit is brought into constant contact with the cooling can roller to remove dust from the circumferential surface of the cooling can roller, due to a cooling operation of the can roller during deposition of a film, the cleaning unit that is in contact with the can roller is also cooled. As a result, the captured dust may fall away from the cleaning unit and be adhered again onto the circumferential surface of the can roller, which is troublesome. In such a case, the function of cleaning the circumferential surface of the can roller deteriorates or the can roller is rather grimed, whereby it becomes impossible to maintain high-quality deposition.

The present invention has been made in view of the above-mentioned problem, and it is therefore an object of the invention to provide a roll-to-roll vacuum deposition method and a roll-to-roll vacuum deposition apparatus that are capable of realizing high-quality deposition while effectively maintaining a cleaning function of a can roller by a cleaning unit. Means for solving the Problem

To solve the problem above, according to the present invention, there is provided a roll-to-roll vacuum deposition method for forming a deposited layer onto a base film while causing the base film to travel in a pressure-reduced atmosphere, including: cleaning, while rotating a can roller in a non-cooled state, the can roller by bringing a cleaning unit into contact with the can roller; canceling an in-contact state of the cleaning unit and the can roller after the cleaning of the can roller is ended; and forming the deposited layer onto the base film while cooling the can roller and bringing the base film into.close contact with the can roller.

Further, according to the present invention, there is provided a roll-to-roll vacuum deposition apparatus for forming a deposited layer onto a base film while causing the base film to travel in a pressure-reduced atmosphere, including: a vacuum chamber; a traveling means for causing the base film to travel inside the vacuum chamber; a can roller for cooling the base film by coming into close contact with the traveling base film; a depositing means disposed opposite to the can roller, for forming the deposited layer onto the base film; a cleaning unit for cleaning the can roller by being brought into contact with the can roller; and a driving mechanism for causing the cleaning unit to be brought into contact with and be detached from the can roller.

In the present invention, because, prior to the deposition onto the base film, the cleaning unit is brought into contact with the can roller so that the can roller is cleaned while being rotated in the non-cooled state, it becomes possible to prevent excessive cooling of the cleaning unit and inhibit fallaway of the removed dust so that the cleaning unit can efficiently carry out the dust removal processing of the can roller.

Moreover, because the in-contact state of the cleaning unit and the can roller is canceled after the cleaning is ended, the cleaning unit can be prevented from being cooled by the cooling operation of the can roller during the deposition, thus making it possible to hold the dust removed from the circumferential surface of the can roller without letting it fall away.

Further, due to the provision of the driving mechanism for causing the cleaning unit to be brought into contact with and be detached from the can roller, an operation of bringing the cleaning unit into contact with the can roller at the time when the cleaning is started and an operation of detaching the cleaning unit from the can roller at the time when the cleaning is ended can automatically be carried out in vacuum from an instruction from outside. The instruction from outside may be a control operation made by an operator or control by a computer performed through execution of a program.

It should be noted that the structure of the cleaning unit is not particularly limited, and a structure that includes an elastic roller that comes into contact with the circumferential surface of the can roller and an adhesive roller for removing dust adhered onto the elastic roller is also possible, for example.

### Effect of the Invention

As described above, according to the present invention, because a stable dust removal effect of the cleaning unit can be maintained, it becomes possible to efficiently carry out the cleaning processing of the can roller in vacuum and thus realize high-quality deposition.

### Brief Description of Drawings

[Fig. 1] A schematic structural diagram of a roll-to-roll vacuum vapor deposition apparatus as a roll-to-roll vacuum deposition apparatus according to an embodiment of the present invention.
[Fig. 2] A perspective diagram showing a schematic structure of a cleaning unit in the roll-to-roll vacuum vapor deposition apparatus shown in Fig. 1.
[Figs. 3] Front views of a main portion of the cleaning unit, in which Fig. 3A shows a view during cleaning and
Fig. 3B shows a view during deposition.
[Fig. 4] A diagram showing an operation flow of the roll-to-roll vacuum vapor deposition apparatus shown in Fig. 1.
[Fig. 5] A diagram showing a result of an experiment investigating a generation condition of a thermal damage to a base film due to a difference in cleaning conditions.

### Description of Reference Numerals

10 roll-to-roll vacuum vapor deposition apparatus
- 11: vacuum chamber
- 12: base film
- 13: payout roller
- 14: can roller
- 15: take-up roller
- 16: evaporation source
- 30: cleaning unit
- 31: first cleaning roller (elastic roller)
- 32: second cleaning roller (adhesive roller)
- 34: driving mechanism

### Best Mode for Carrying Out the Invention

Hereinafter, an embodiment of the present invention will be described with reference to the drawings. In this embodiment, descriptions will be given on an example where the present invention is applied to a roll-to-roll vacuum vapor deposition apparatus as a roll-to-roll vacuum deposition apparatus.

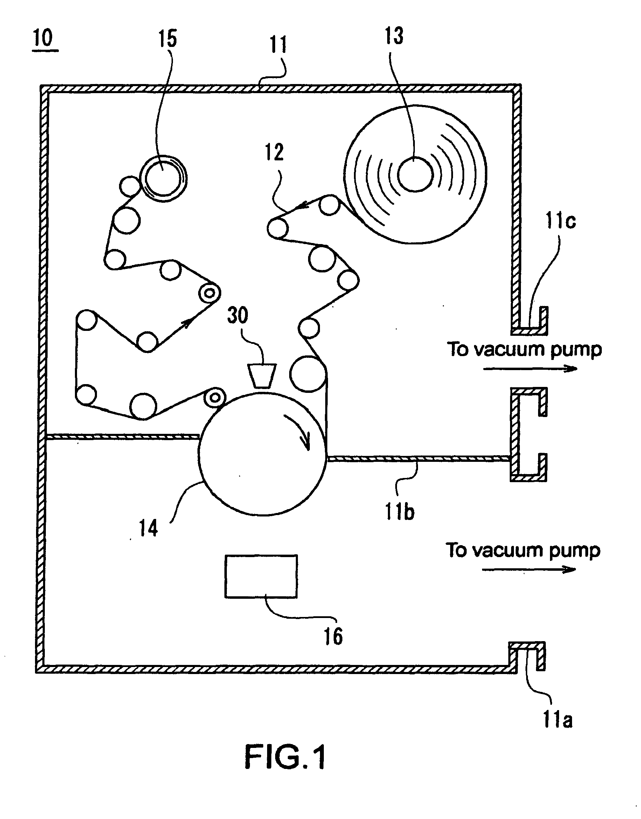

Fig. 1 is a schematic structural diagram of a roll-to-roll (take-up-type) vacuum vapor deposition apparatus 10 according to the embodiment of the present invention. The roll-to-roll vacuum vapor deposition apparatus 10 of this embodiment includes a vacuum chamber 11, a payout roller 13 for a base film 12, a
can roller 14, a take-up roller 15 for the base film 12, and an evaporation source 16 of an evaporation material.

The vacuum chamber 11 is connected to a vacuum exhaust system such as a vacuum pump (not shown) via pipe connection portions 11a and 11c, and is exhausted to reduce a pressure inside to a predetermined vacuum degree. An internal space of the vacuum chamber 11 is sectioned by a partition plate 11b into a room in which the payout roller 13, the take-up roller 15, and the like are disposed, and a room in which the evaporation source 16 is disposed.

The base film 12 is constituted of a long plastic film having an insulation property and cut at a predetermined width. For example, an OPP (oriented polypropylene) film, a PET (polyethylene terephthalate) film, a PPS (polyphenylene sulfide) film, a PI polyimide) film, or a metal foil is used. The base film 12 is paid out from the payout roller 13 and is taken up by the take-up roller 15 via a plurality of guide rollers and the can roller 14. It should be noted that although not shown, each of the payout roller 13 and the take-up roller 15 is provided with a rotary drive portion.

The can roller 14 is tubular and made of metal such as stainless steel or iron. Inside, the can roller 14 has a cooling mechanism such as a cooling medium circulation system, a rotary drive mechanism for rotationally driving the can roller 14, and the like. The base film 12 is wound around a circumferential surface of the can roller 14 at a predetermined holding angle. The base film 12 wound around the can roller 14 is deposited with, on a deposition surface on an outer surface side thereof, an evaporation material from the evaporation source 16 so as to form a deposited layer, and at the same time, is cooled by the can roller 14. During deposition onto the base film 12, the can roller 14 is maintained at a predetermined cooling temperature (e.g., -20°C) by the cooling mechanism.

The payout roller 13, the can roller 14, the take-up roller 15, and the other guide rollers above constitute a "traveling means" of the present invention for causing the base film 12 to travel inside the vacuum chamber 11.

The evaporation source 16 accommodates the evaporation material and has a mechanism for causing the evaporation material to evaporate by heating using a well-known technique such as resistance, heating, induction heating, and electron beam heating. The evaporation source 16 is disposed below the can roller 14 and causes the vapor of the evaporation material to adhere onto the base film 12 on the can roller 14 opposed thereto, to thus form a deposited layer. It should be noted that the evaporation source 16 corresponds to a "depositing means" of the present invention for depositing a deposition material.onto the traveling base film 12.

As the evaporation material, in addition to a metal element single body such as Al (aluminum), Co (cobalt), Cu (copper), Ni (nickel), and Ti (titanium), two or more metals such as Al-Zn (zinc), Cu-Zn, and Fe (iron)-Co, or a multi-component alloy is applicable. In addition, the number of evaporation source 16 is not limited to one, and a plurality of evaporation sources may be provided.

Next, a cleaning unit 30 of the can roller 14 according to the present invention will be described.

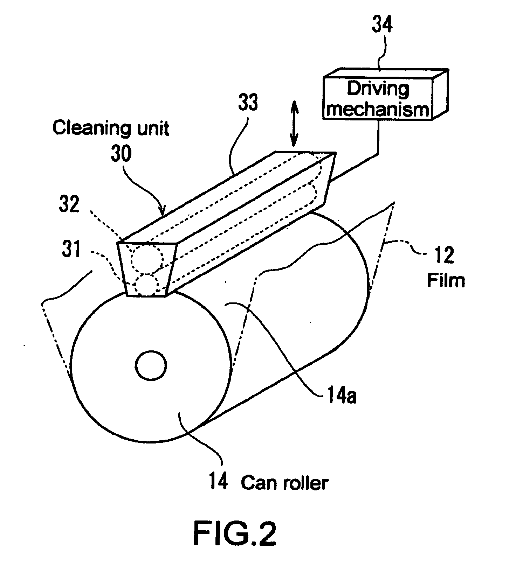

Fig. 2 is a perspective diagram showing an entire schematic structure of the cleaning unit 30. The cleaning unit 30 is disposed above the can roller 14 at a portion thereof around which the base film 12 is not wound. The cleaning unit 30 includes a first cleaning roller 31 for removing dust adhered onto a circumferential surface 14a of the can roller 14 by being brought into contact with the circumferential surface 14a of the can roller 14, and a second cleaning roller 32 for removing the dust captured by the first cleaning roller 31, from the first cleaning roller 31. The first and second cleaning rollers 31 and 32 each have at least a shaft length corresponding to a width of the base film 12, or a shaft length enough to cover a circumferential surface area of the can roller 14 that comes into contact with the base film 12, and both end portions of the rollers are rotatably supported by a casing 33.

In this embodiment, the first cleaning roller 31 is constituted of an elastic roller that adsorbs dust by static electricity, whereas the second cleaning roller 32 is constituted of an adhesive roller that removes the dust by coming into contact with the first cleaning roller 31. The elastic roller 31 and the adhesive roller 32 are structured to rotate along with the can roller 14 during the cleaning of the can roller 14.

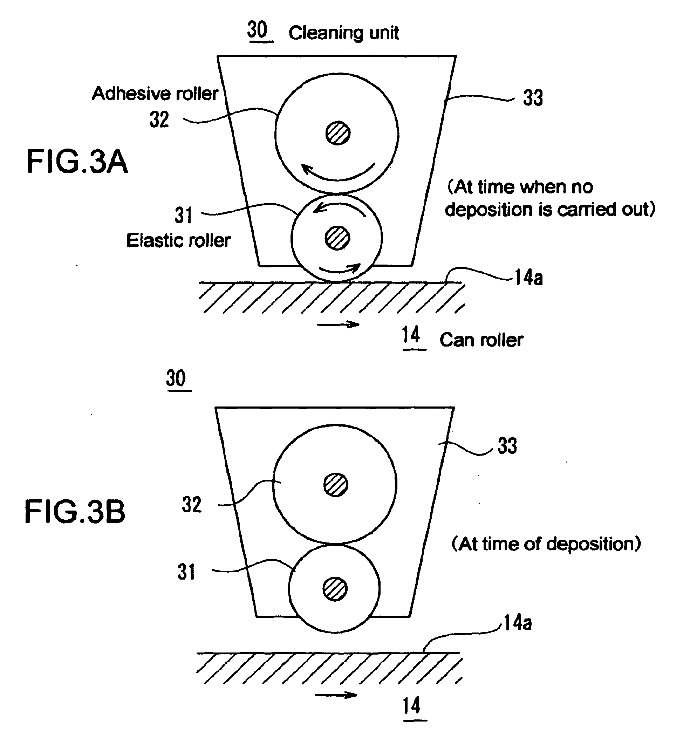

Figs. 3A and 3B are front views of a main portion of the cleaning unit 30 for explaining an operation thereof. In this embodiment, cleaning processing of the can roller 14 by the cleaning unit 30 is carried out only when no deposition is carried out with respect to the base film 12 as shown in Fig. 3A, and after the cleaning processing is ended, the cleaning unit 30 is detached from the can roller 14 as shown in Fig. 3B. The operation of causing the cleaning unit 30 to be brought into contact with and be detached from the can roller 14 is made by a driving mechanism 34 (Fig. 2) attached to the casing 33.

The driving mechanism 34 is used for causing the casing 33 to reciprocate linearly in a radial direction of the can roller 14, and is constituted of a driving motor or a cylinder apparatus disposed either inside or outside the vacuum chamber 11. The driving mechanism 34 is driven and controlled based on an instruction from outside the vacuum chamber 11. The instruction from outside may be a control operation made by an operator or control by a computer performed through execution of a program.

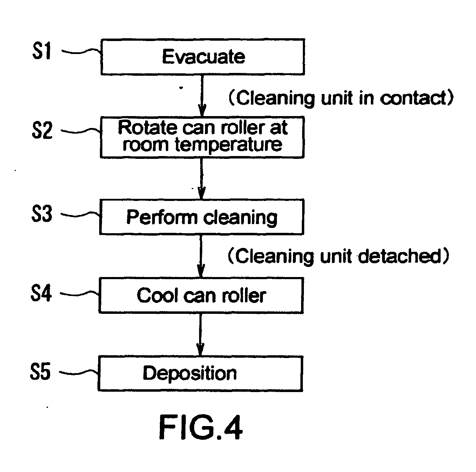

Subsequently, an operation of the thus-structured roll-to-roll vacuum vapor deposition apparatus 10 of this embodiment will be described. Fig. 4 shows an operation flow of the roll-to-roll vacuum vapor deposition apparatus 10.

First, the vacuum chamber 11 is evacuated so as to be pressure-reduced inside to a predetermined vacuum pressure (Step S1). This process is carried out at a time of activating the apparatus, such as at a start of production (after setting a new film). At this time, the base film 12 is already paid out from the payout roller 13 and passed over to the take-up roller 15 via the can roller 14 and various guide rollers. Further, the cleaning unit 30 is in a non-contact state with the can roller 14 as shown in Fig. 3B.

Next, the driving mechanism 34 is driven to lower the cleaning unit 30. Then, the can roller 14 is rotated in a non-cooled state (Step S2). Therefore, the can roller 14 is maintained at room temperature. Accordingly, the elastic roller 31 comes into contact with the circumferential surface 14a of the can roller 14 as shown in Fig. 3A and the cleaning processing of the circumferential surface 14a of the can roller 14 is started (Step S3).

In this cleaning process, the dust adhered onto the circumferential surface 14a of the can roller 14 is removed by being adsorbed by static electricity of the elastic roller 31, whereby the circumferential surface 14a of the can roller 14 is cleaned. On the other hand, the dust adhered onto a circumferential surface of the elastic roller 31 is removed by the adhesive roller 32, whereby the circumferential surface of the elastic roller 31 is also kept clean at all times, thus enhancing cleaning efficiency of the can roller 14.

In this embodiment, the cleaning processing of the can roller 14 is carried out while rotating the can roller 14 in the non-cooled state, prior to deposition processing with respect to the film 12. Accordingly, it becomes possible to prevent excessive cooling of the elastic roller 31 and the adhesive roller 32 constituting the cleaning unit 30 and inhibit fallaway of the removed dust so that the cleaning unit 30 can efficiently carry out the dust removal processing of the can roller 14.

Next, when the cleaning of the can roller 14 is ended, the driving mechanism 34 is driven to raise the cleaning unit 30 so that the cleaning unit 30 is detached from the circumferential surface of the can roller 14 as shown in Fig. 3B, and the can roller 14 is thereafter cooled to a predetermined cooling temperature (Step S4). Then, the deposition processing with respect to the base film 12 is started (Step S5).

In this embodiment, because the in-contact state of the cleaning unit 30 and the can roller 14 is canceled after the cleaning of the can roller 14 is ended, it is possible to prevent the cleaning unit 30 from being cooled by the cooling operation of the can roller 14 during deposition, that is, prevent deterioration of an adhesive surface of the adhesive roller 32 by the cooling operation, and thus stably hold the dust removed from the circumferential surface of the can roller 14. Accordingly, a pinhole in a film caused by the fallen-away dust adhering again onto the can roller 14 and a thermal damage such as wrinkles or puckering of the base film 12 can be prevented.

As described above, according to this embodiment, a stable dust removal effect of the cleaning unit 30 can be maintained. Therefore, it is possible to efficiently carry out the cleaning processing of the can roller 14 in vacuum to thus realize high-quality deposition processing.

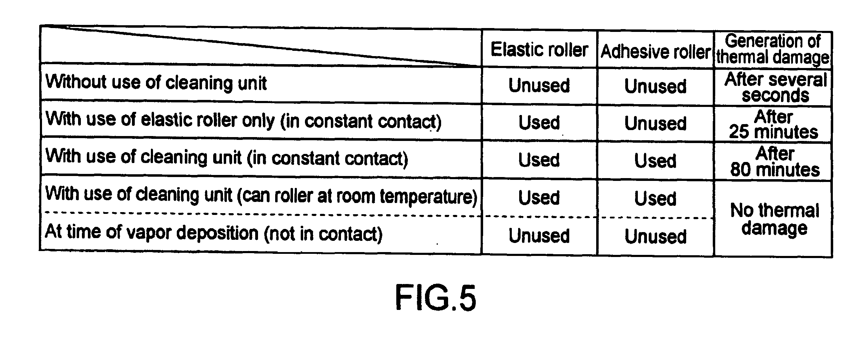

Here, Fig. 5 shows a result of an experiment investigating a generation condition of a thermal damage in the base film during the deposition processing, after carrying out the cleaning of the can roller under various cleaning conditions.
First, in the case of the deposition without the use of the cleaning unit (without cleaning the can roller), a thermal damage in the base film was confirmed after several seconds since the start of the deposition.
In the case where, in the cleaning processing using only the elastic roller, the elastic roller is brought into constant contact with the can roller, the thermal damage was generated after 25 minutes since the start of the deposition.
On the other hand, in the case where both the elastic roller and the adhesive roller are used and the elastic roller is brought into constant contact with the can roller, the thermal damage was generated after 80 minutes since the start of the deposition.
In contrast, in the case of using both the elastic roller and the adhesive roller to carry out the cleaning while the can roller is maintained in its non-cooled state (room temperature) and detaching the elastic roller from the can roller after the cleaning is ended, no thermal damage in the base film was confirmed.

The descriptions above have been given on the embodiment of the present invention.

For example, the above embodiment has described the example of depositing a metal layer by applying the vacuum vapor deposition method that uses the evaporation source 16 as the depositing means. However, the present invention is not limited thereto, and other deposition methods for depositing a metal or nonmetal layer, such as a sputtering method or various CVD methods, are also applicable. Furthermore, a depositing means including a sputtering target can be appropriately adopted in accordance with those deposition methods.

## Claims

1. A roll-to-roll vacuum deposition method for forming a deposited layer onto a base film (12) while causing the base film to travel in a pressure-reduced atmosphere, **characterised in that** the method comprises:
cleaning, while rotating a can roller (14) in a non-cooled state, the can roller by bringing a cleaning unit (30) into contact with the can roller;
cancelling an in-contact state of the cleaning unit and the can roller after the cleaning of the can roller is ended; and
forming the deposited layer onto the base film (12) while cooling the can roller and bringing the base film into close contact with the can roller.

2. The roll-to-roll vacuum deposition method according to claim 1,
wherein an operation of causing the cleaning unit to be brought into contact with and be detached from the can roller is made by a remote operation from outside.

3. A roll-to-roll vacuum deposition apparatus (10) for forming a deposited layer onto a base film (12) while causing the base film (12) to travel in a pressure-reduced atmosphere, comprising:
a vacuum chamber (11);
a traveling means (13, 15) for causing the base film (12) to travel inside the vacuum chamber (11);
a can roller (14) for cooling the base film (12) by coming into close contact with the traveling base film (12);
a depositing means (16) disposed opposite to the can roller (14), for depositing the deposited layer onto the base film (12); **characterised in that** the apparatus further comprises:
a cleaning unit (30) for cleaning the can roller (14) by being brought into contact with the can roller (14); and
a driving mechanism (34) for causing the cleaning unit (30) to be brought into contact with and be detached from the can roller (14).

4. The roll-to-roll vacuum deposition apparatus according to claim 3,
wherein the driving mechanism (34) causes the cleaning unit (30) to be brought into contact with the can roller (14) in a non-cooled state, and cancels an in-contact state of the cleaning unit (30) and the can roller (14) after the cleaning of the can roller (14) is ended.

5. The roll-to-roll vacuum deposition apparatus according to claim 3,
wherein the cleaning unit (30) includes a first cleaning roller (31) for cleaning a circumferential surface of the can roller (14) and a second cleaning roller (32) for cleaning the first cleaning roller (31).

6. The roll-to-roll vacuum deposition apparatus according to claim 5,
wherein the first cleaning roller (31) is an elastic roller, and
wherein the second cleaning roller (32) is an adhesive roller.

## Patentansprüche

1. Von Rolle-zu-Rolle Vakuumabscheideverfahren zum Bilden einer abgeschiedenen Schicht auf einem Trägerfilm (12), während der Trägerfilm veranlasst wird, sich in einer druckreduzierten Atmosphäre zu bewegen, **dadurch gekennzeichnet, dass** das Verfahren aufweist:
Reinigen einer Becherrolle, während sich die Becherrolle (14) in einem nicht gekühlten Zustand dreht, durch in Kontakt bringen einer Reinigungseinheit (30) mit der Becherrolle,
Aufheben eines in Kontakt-Zustands der Reinigungseinheit und der Becherrolle, nachdem die Reinigung der Becherrolle beendet ist, und
Bilden der abgeschiedenen Schicht auf dem Trägerfilm (12), während die Becherrolle gekühlt wird und der Trägerfilm in engen Kontakt mit der Becherrolle gebracht wird.

2. Von Rolle-zu-Rolle Vakuumabscheideverfahren nach Anspruch 1, wobei eine Betätigung, die bewirkt, dass die Reinigungseinheit in Kontakt mit der Becherrolle gebracht wird und von dieser entfernt wird, durch eine ferngesteuerte Betätigung von Außerhalb ausgeführt wird.

3. Von Rolle-zu-Rolle Vakuumabscheidevorrichtung (10) zum Bilden einer abgeschiedenen Schicht auf einem Trägerfilm (12), während bewirkt wird, dass sich der Trägerfilm (12) in einer druckreduzierten Atmosphäre bewegt, mit:
einer Vakuumkammer (11),
einem Bewegungsmittel (13, 15) zum Bewirken, dass sich der Trägerfilm (12) innerhalb der Vakuumkammer (11) bewegt,
einer Becherrolle (14) zum Kühlen des Trägerfilms (12) durch enges in Kontakt kommen mit dem sich bewegenden Trägerfilm (12),
einem Abscheidemittel (16), das gegenüber der Becherrolle (14) angeordnet ist, zum Abscheiden der abgeschiedenen Schicht auf dem Trägerfilm (12), **dadurch gekennzeichnet, dass** die Vorrichtung darüber hinaus aufweist:
eine Reinigungseinheit (30) zum Reinigen der Becherrolle (14), dadurch, dass diese in Kontakt mit der Becherrolle (14) gebracht wird, und
einem Antriebsmechanismus (34) zum Bewirken, dass die Reinigungseinheit (30) in Kontakt mit der Becherrolle (14) gebracht wird und von dieser entfernt wird.

4. Von Rolle-zu-Rolle Vakuumabscheidevorrichtung nach Anspruch 3,
wobei der Antriebsmechanismus (34) bewirkt, dass die Reinigungseinheit (30) in Kontakt mit der Becherrolle (14) in einen nicht gekühlten Zustand gebracht wird und einen in Kontakt-Zustand der Reinigungseinheit (30) und der Becherrolle (14) aufhebt, nachdem die Reinigung der Becherrolle (14) beendet ist.

5. Von Rolle-zu-Rolle Vakuumabscheidevorrichtung nach Anspruch 3,
wobei die Reinigungseinheit (30) eine erste Reinigungsrolle (31) zum Reinigen einer Umfangsoberfläche der Becherrolle (14) und eine zweite Reinigungsrolle (32) zum Reinigen der ersten Reinigungsrolle (31) aufweist.

6. Von Rolle-zu-Rolle Vakuumabscheidevorrichtung nach Anspruch 5,
wobei die erste Reinigungsrolle (31) eine elastische Rolle ist und
wobei die zweite Reinigungsrolle (32) eine klebende Rolle ist.

## Revendications

1. Procédé de dépôt sous vide par rouleau pour former une couche déposée sur un film de base (12), tout en obligeant le film de base à se déplacer dans une atmosphère à pression réduite, **caractérisé en ce que** le procédé comprend :
le nettoyage d'un rouleau à enveloppe métallique (14), tout en faisant tourner le rouleau à enveloppe métallique dans un état non refroidi, en mettant une unité de nettoyage (30) en contact avec le rouleau à enveloppe métallique ;
l'annulation d'un état de contact entre l'unité de nettoyage et le rouleau à enveloppe métallique après que le nettoyage du rouleau à enveloppe métallique est terminé ; et
la formation de la couche déposée sur le film de base (12) tout en refroidissant le rouleau à enveloppe métallique et en mettant le film de base en contact étroit avec le rouleau à enveloppe métallique.

2. Procédé de dépôt sous vide par rouleau selon la revendication 1,
dans lequel une opération obligeant l'unité de nettoyage à entrer en contact avec le rouleau à enveloppe métallique et à se séparer de celui-ci est exécutée par une opération distante depuis l'extérieur.

3. Appareil de dépôt sous vide par rouleau (10) pour former une couche déposée sur un film de base (12), tout en obligeant le film de base à se déplacer dans une atmosphère à pression réduite, comprenant :
une chambre à vide (11) ;
un moyen mobile (13, 15) pour obliger le film de base (12) à se déplacer à l'intérieur de la chambre à vide (11) ;
un rouleau à enveloppe métallique (14) pour refroidir le film de base (12) en entrant en contact étroit avec le film de base (12) en mouvement ;
un moyen de dépôt (16) disposé à l'opposé du rouleau à enveloppe métallique (14), pour déposer la couche déposée sur le film de base (12) ;
**caractérisé en ce que** l'appareil comprend en outre :
une unité de nettoyage (30) pour nettoyer le rouleau à enveloppe métallique (14) en la mettant en contact avec le rouleau à enveloppe métallique (14) ;
un mécanisme d'entraînement (34) pour obliger l'unité de nettoyage (30) à venir en contact avec le rouleau à enveloppe métallique (14) et à se séparer de celui-ci.

4. Appareil de dépôt sous vide par rouleau selon la revendication 3,
dans lequel le mécanisme d'entraînement (34) oblige l'unité de nettoyage (30) à venir en contact avec le rouleau à enveloppe métallique (14) dans un état non refroidi, et annule un état de contact entre l'unité de nettoyage (30) et le rouleau à enveloppe métallique (14) après que le nettoyage du rouleau à enveloppe métallique (14) est terminé.

5. Appareil de dépôt sous vide par rouleau selon la revendication 3,
dans lequel l'unité de nettoyage (30) comprend un premier rouleau de nettoyage (31) pour nettoyer une surface périphérique du rouleau à enveloppe métallique (14) et un deuxième rouleau de nettoyage (32) pour nettoyer le premier rouleau de nettoyage (31).

6. Appareil de dépôt sous vide par rouleau selon la revendication 5,
dans lequel le premier rouleau de nettoyage (31) est un rouleau élastique, et le deuxième rouleau de nettoyage (32) est un rouleau adhésif.
